# EUROPEAN PATENT APPLICATION

(11) **EP 2 482 448 A1**
(43) Date of publication of application: **01.08.2012**
(21) Application number: 11290063.4
(22) Date of filing: 31.01.2011
(51) Int. Cl.: H03F 1/02, H03F 1/32, H03F 1/56, H03F 3/24

(54) **Doherty amplifier and method of operating a Doherty amplifier**

(71) Applicant: Alcatel Lucent, 75007 Paris (FR)
(72) Inventor: Wiegner, Dirk, 71409 Schwalkheim (DE)
(74) Representative: Kleinbub, Oliver

(57) **Abstract**

The invention relates to a Doherty amplifier (100) comprising a primary amplification path (110) for amplifying an input signal (in), a plurality of secondary amplification paths (120a, 120b) for amplifying specific frequency sub-ranges of said input signal (in), and signal processing means (130) which comprise at least two preprocessing branches (132, 134, 136), wherein a first preprocessing branch (132) is configured to supply said primary amplification path (110) with a primary input signal (in1) derived from said input signal (in), and wherein at least one further preprocessing branch (134, 136) is configured to supply at least one of said secondary amplification paths (120a, 120b) with a secondary input signal (in2, in3) derived from said input signal (in).

## Description

### Background of the invention

The present invention relates to a Doherty amplifier and a method of operating a Doherty amplifier.

Different radio frequency transmitting technologies like WiMAX, UMTS, GSM with different specifications working in different frequency ranges usually need their own processing techniques and hardware. To decrease costs and efforts it will be helpful to get several of these technologies combined (e.g. mandatory for SDR (Software Defined Radio) or cognitive Radio applications). Therefore, it is necessary to cover high frequency bandwidths and to have power amplifiers covering frequency bands over a wide frequency range. Additionally, efficiency is a main problem of power amplifiers for modern base stations of cellular communications networks, which clearly influences e.g. material costs, cooling effort, mechanical transmitter size and operating costs (CAPEX and OPEX). Thus, energy efficiency becomes an important parameter and selling factor. However, due to increased linearity requirements, associated with new complex modulation schemes which are necessary in order to meet the increased demand for high data rates, the realization of highly efficient linear amplifiers becomes more and more complicated. The above-described situation is especially true for multi-band / multi-standard capable base stations (SDR, Cognitive Radio), since they have to cover different requirements for different frequency bands and different communication standards using the same hardware while maintaining high construction and operational efficiency.

Although it is possible to use conventional class-AB based amplifiers as multi-band amplifiers, these would only achieve moderate efficiency for modern communication standards. As beside bandwidth, another important goal is to increase efficiency, output power, linearity etc. over the whole bandwidth, the main problem is to transfer the performance known from narrow-band (single-band) amplifiers to amplifiers with a higher bandwidth. This is especially true e.g, for the Doherty amplifier configuration, which is a promising concept for efficiency-improved single-band amplifiers.

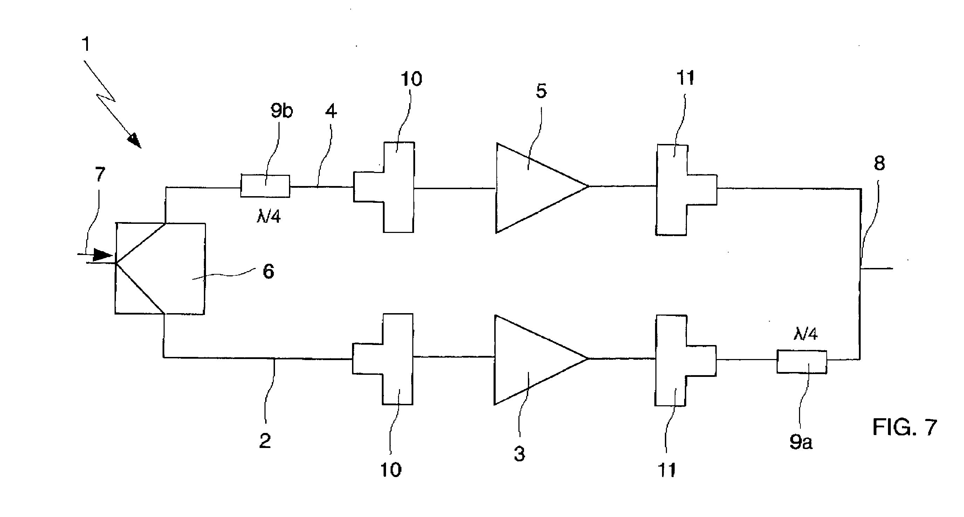

The classical configuration of a conventional Doherty power amplifier 1 is shown in Fig. 7. The Doherty amplifier 1 comprises a main amplification path 2 with a main amplifier 3 biased to work in class AB mode, and an auxiliary amplification path 4 with a peak amplifier 5 biased to operate in class C mode.

A power divider (passive splitter 6) splits an input signal 7 with equal power to the main amplification path 2 and to the auxiliary amplification path 4. After amplification, the auxiliary amplification path 4 and the main amplification path 2 are re-combined in a power combiner (not shown) at a combining point 8. For optimized load balancing, a first quarter wave section 9a is arranged in the main amplification, path 2 between the output end of the main amplifier 3 and the combining point 8 and a second quarter wave section 9b is arranged in the auxiliary amplification path 4 between the splitter 6 and an input end of the auxiliary amplifier 5. The quarter-wave sections 9a, 9b are matched to a common center frequency of the main amplifier 3 and the peak amplifier 5 which are adapted to operate at that center frequency by respective input and output matching networks 10, 11. During high signal peaks of the input signal 7, the main amplifier 3 saturates and the peak amplifier 5 kicks in. Thus, the Doherty amplifier 1 provides a high power-added efficiency with input signals 7 that have high peak-to-average ratios. However, due to the bandwidth-limiting quarter-wave sections 9a, 9b and load modulation, which are fundamental parts of the Doherty concept, conventional Doherty amplifiers are bandwidth-limited, i.e. are only adapted to amplify a narrow frequency band about the center frequency.

Accordingly, it is an object of the present invention to provide an improved Doherty amplifier and an improved method of operating a Doherty amplifier which offer an increased operational flexibility.

Regarding the Doherty amplifier, according to the present invention, said object is achieved by said Doherty amplifier comprising a primary amplification path for amplifying an input signal, and a plurality of secondary amplification paths for amplifying specific frequency sub-ranges of said input signal. Preferably, the main amplification path comprises a main amplifier which is wideband matched so as to amplify a substantial frequency range of the input signal, whereas said at least two secondary amplification paths preferably comprise respective peak amplifiers, wherein said peak amplifiers are matched to specific, preferably different, center frequencies within said frequency range of the input signal thus offering optimized amplification of said specific frequency sub-ranges of said input signal.

I.e., the plurality of secondary amplification paths, each of which is provided to amplify at least one specific frequency sub-range of the input signal advantageously enables to provide an optimized operation of said Doherty amplifier depending on the spectral components of the input signal to be amplified. For instance, if an input signal is to be amplified having a first center frequency, the primary amplification path and a first one of said secondary amplification paths may be employed, wherein the first one of the secondary amplification paths is especially configured for amplifying signals within the first center frequency range. In analogy, amplification of an input signal having another, different center frequency, may advantageously be accomplished by using the same primary amplification path and a further one of said secondary amplification paths, wherein said further secondary amplification path is optimized for the second center frequency. Obviously, the principle of the embodiments is not limited to two secondary amplification paths. It is rather also possible to provide more than two secondary amplification paths.

According to a preferred embodiment, the primary amplification path comprises a wideband matched main amplifier, whereas the secondary amplification paths each comprise a peak amplifier that is optimized for amplifying a specific sub-range of the frequency range processed by the main amplifier. As such, the peak amplifiers of the secondary amplification paths correspond to the single auxiliary amplification path 4 of the prior art Doherty amplifier 1 as depicted by Fig. 7, and the main amplifier of the primary amplification path according to the embodiments corresponds to the main amplification path 2 of the prior art Doherty amplifier 1 as depicted by Fig. 7.

However, the various amplifiers of the inventive amplification paths are not restricted to specific amplifier modes of operation (e.g., class-AB, class-C). According to an embodiment, it is rather possible to provide different amplifier configurations within each amplification path.

Further, according to the present invention, signal processing means are provided which enable an individual signal processing within associated preprocessing branches. Thus, advantageously, an individual signal processing can be performed within the respective preprocessing branches for different amplification paths of the Doherty amplifier according to the embodiments. For instance, a first preprocessing branch can advantageously be configured to derive a primary input signal from the input signal, wherein said primary input signal is optimized for amplification by the primary amplification path, e.g. regarding a wideband amplification or the like. Moreover, a further preprocessing branch may advantageously be optimized to derive a secondary input signal depending on the input signal, wherein said secondary input signal may be optimized for at least one of the secondary amplification paths.

Thus, in contrast to conventional Doherty amplifiers, which provide a passive splitter (cf. device 6 of Fig. 7) as a power divider for distributing the input signal to the main amplification path and a secondary amplification path, the present embodiments advantageously enable to individually process an input signal within the processing means or its preprocessing branches, respectively, whereby an optimum signal conditioning maybe performed on a per-amplification path basis. I,e., each amplification path may advantageously be provided with an individually processed respective input signal, that is derived from the global input signal to the Doherty amplifier. Thus, a maximum operational flexibility is given.

According to an advantageous embodiment, at least one preprocessing branch comprises a mixer for upconverting a signal processed within said preprocessing branch. For instance, by providing a local oscillator signal related to a desired destination frequency range, the input signal or a portion thereof or any other signal processed within the preprocessing branch, such as e.g. a signal derived from said input signal, may - in a per se known manner - be upconverted to the desired frequency range such as e.g. the radio frequency (RF) range.

For instance, if the input signal provided to the Doherty amplifier represents a baseband signal, the mixer provided within the at least one preprocessing branch may be utilized for upconverting the baseband input signal to a desired radio frequency range, which e.g. enables to transmit the amplified signal via an antenna over an air interface.

However, it is also possible to process input signals which comprise an intermediate frequency (IF) range.

According to a further embodiment, the preprocessing branches do not necessarily comprise a mixer. For instance, the input signal for the Doherty amplifier may already be provided in a frequency range which is suitable for e.g. transmission via an air interface. In this case, no upconversion and thus no mixer is required. However, the corresponding signal processing components of the Doherty amplifier have to have a sufficient processing bandwidth to handle such input signals.

According to a further embodiment, at least one preprocessing branch comprises amplifying means, which advantageously enables to individually amplify and/or attenuate signals processed within the respective preprocessing branches. For instance, according to a particularly preferred embodiment, the amplifying means may be configured for applying a controllable gain and/or attenuation to a signal processed within said preprocessing branch. Advantageously, different preprocessing branches may comprise controllable amplifying means each, wherein different amplification/attenuations regarding the various input signals for the primary amplification path and the secondary amplification path(s) may be established.

According to a further embodiment, at least one preprocessing branch comprises digital to analog, D/A, converter means which advantageously enable to receive digital input signals at an input of the Doherty amplifier and to at least partially process the input signals within the digital domain, e.g. by means of digital signal processing structures such as a digital signal processor (DSP). For example, the Doherty amplifier may be configured to comprise an input port for receiving a digital baseband input signal. The digital baseband input signal may be processed according to predetermined algorithms in the digital domain. After that, the processed digital signal may be converted to the analog domain by means of said at least one digital to analog converter, and after that, the analog signal may e.g. be further processed by the various preprocessing branches within the analog domain. Such further processing may e.g. comprise an upconversion from the baseband (or IF) range to the desired target frequency range, e.g. the RF range.

According to a further advantageous embodiment, at least one preprocessing branch comprises digital signal processing means for applying digital signal processing algorithms to a signal processed within said preprocessing branch. Generally, the different preprocessing branches of the Doherty amplifier according to the embodiments may advantageously be implemented within a single digital signal processor or application specific integrated circuit (ASIC) or a programmable logic array, such as an FPGA (Field Programmable Gate Array),

However, apart from implementing- the functionality of the various preprocessing branches within the digital signal processor, it is also possible to additionally provide a central digital signal processing capability which may e.g. be realized in the form of a control unit. Such control unit may e.g. apply basic digital signal processing to the input signal supplied to the various preprocessing branches of the Doherty amplifier.

According to a further advantageous embodiment, the at least one further preprocessing branch comprises switching means for selectively supplying at least one of the secondary amplification paths with said secondary input signal. This advantageously enables to e.g. operate either a first one of said secondary amplification paths, which may be optimized for a first center frequency, or a second one of said secondary amplification paths, which may e.g. be optimized for a different center frequency, with said secondary input signal.

Of course, the amplifying means comprised within the different secondary amplification paths that are served by the preprocessing branches may selectively be deactivated depending on an operational state of the preprocessing branches.

According to a further embodiment, said at least one further preprocessing branch comprises splitter means for supplying a plurality of said secondary amplification paths with said secondary input signal. This configuration advantageously enables to simultaneously operate different ones of the secondary amplification paths based on a specific secondary input signal provided by the respective preprocessing branch comprising said splitter means.

According to a further advantageous embodiment, said at least one further preprocessing branch comprises filter means for filtering a signal processed within said preprocessing branch. It is particularly advantageous to provide the filter means after, i.e. at an output of, the aforementioned splitter means so as to enable to provide differently filtered instances of the secondary input signal to the respective secondary amplification paths thus further supporting an optimization of the different secondary amplification paths regarding a respective center frequency.

For instance, by applying only a single preprocessing branch, which comprises the splitter and respective filter means, it is advantageously possible to supply at least two subsequent secondary amplification paths with secondary input signals to be amplified which comprise different frequency spectra.

According to a further advantageous embodiment, an output signal combining network is provided which is configured to receive output signals of a plurality of amplification paths and to add the output signals to obtain an aggregated output signal. The output signal combining network advantageously combines the different signals which have individually been amplified by the respective primary and secondary amplification paths of the Doherty amplifier according to the embodiments.

Apart from comprising transmission lines and/or matching networks for the respective frequency ranges of the signals to be amplified and combined, the output signal combining network may also comprise directional couplers or other elements suitable for adding radio frequency signals to each other while at the same time providing for signal path isolation in a reverse direction, i.e. in order to prevent output signals from a first amplification path to enter a second amplification path in reverse direction.

Still further, the output signal combining network may comprise various radio frequency switches such as e.g. diodes, e.g. PIN diodes, which may - in a per se known manner - be controlled to be conductive or non-conductive by applying a predetermined direct current voltage thus effecting a high conductivity for radio frequency signals or not.

According to a further advantageous embodiment, said signal processing means are configured to apply at least one of the following processing steps to said input signal: linearization, clipping, digital path control for distributing specific portions (e.g., spectral portions or amplitude portions or the like) of said input signal to different preprocessing branches. Said digital path control may e.g. also comprise a first step of filtering, wherein a first group of spectral components of the input signal is forwarded to the primary amplification path, and wherein a second group of spectral components of the input signal is forwarded to at least one secondary amplification path.

According to a further advantageous embodiment, a control unit is provided which is configured to control an operation of said Doherty amplifier, particularly configured to:
- control a gain and/or attenuation applied to a signal processed within a preprocessing branch,
- control switching means of said preprocessing branch,
- control a supply voltage for an amplifier comprised within said primary amplification path and/or said secondary amplification path,
- control an operation of said output signal combining network.

Regarding the control of a supply voltage for an amplifier comprised within said primary amplification path and/or said secondary amplification path, it is e.g. possible to completely turn on or off the respective devices (amplifiers or further active devices of the path). However, alternatively or in addition, it is also possible to provide different supply voltages depending e.g. on a load situation and/or further operational parameters of the amplifier. Providing different supply voltages may e.g. be accomplished by means of controllable or "multi-level" DC (direct current)/DC converters.

A further solution to the object of the present invention is given by a method of operating a Doherty amplifier according to claim 12. The method proposes that a first preprocessing branch supplies said primary amplification path of the Doherty amplifier with a primary input signal derived from said input signal, and that at least one further preprocessing branch supplies at least one of said secondary amplification paths with a secondary input signal derived from said input signal.

According to a particularly advantageous embodiment, a single one of said secondary amplification paths is activated at a time by a control unit thus increasing the energy efficiency of the Doherty amplifier.

I.e., amplification path which are currently not required for amplification operation may be temporarily be activated by the control unit.

In a further advantageous embodiment, a plurality of preprocessing branches use the same local oscillator signal for upconverting a signal processed within said preprocessing branches.

According to yet another advantageous embodiment, the primary and secondary input signals are processed individually for at least two, preferably all, amplification paths, within the preprocessing branches, which offers a maximum operational flexibility.

### Brief description of the figures

Further aspects, features and embodiments of the present invention are given in the following detailed description, with reference to the drawings in which:
- figure 1: depicts a simplified block diagram of a Doherty amplifier according to an embodiment,
- figures 2a, 2b, 2c, 2d: depict simplified block diagrams of a preprocessing branch architecture according to the embodiments,
- figures 3a, 3b, 3c: depict simplified block diagrams of preprocessing branch architectures of further embodiments,
- figure 4: depicts a simplified block diagram of an output signal combining network according to an embodiment ,
- figure 5: depicts a simplified block diagram of a Doherty amplifier according to a further embodiment,

- figure 6: depicts a simplified flow chart of a method according to the embodiments, and
- figure 7: depicts a Doherty amplifier according to prior art.

### Description of the embodiments

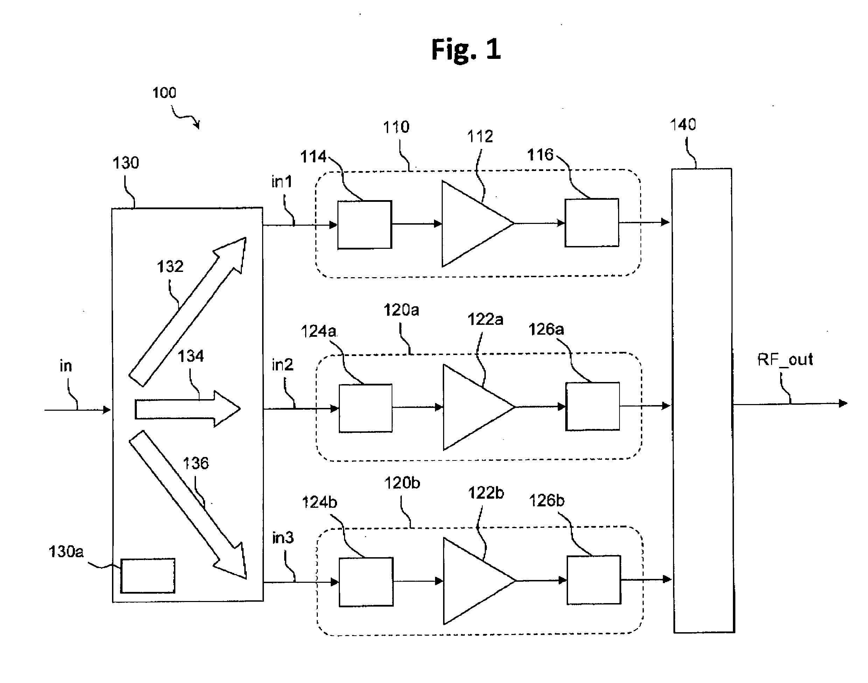

Figure 1 depicts a simplified block diagram of a Doherty amplifier 100 according to an embodiment of the present invention. The Doherty amplifier 100 comprises a primary amplification, path 110 which is configured to amplify an input signal. As such, basically, the primary amplification path 110 corresponds to the main amplification path 2 of the conventional Doherty amplifier depicted by Fig. 7. More specifically, the primary amplification path 110 of the embodiment according to Fig. 1 is configured as a wideband amplifier in that it provides sufficient amplification of an input signal within the frequency range of the input signal in. For this purpose, the primary amplification path 110 comprises a wideband main amplifier 112. At an input of said main amplifier 112, an input matching network 114 is provided which is configured to establish an input signal matching (e.g., impedance transformation and the like) of the amplifier 112 in a per se known manner. Likewise, at an output of the main amplifier 112, the primary amplification path 110 comprises an output matching network 116, which is configured for matching the output of the main amplifier 112 to a comparatively wide frequency range, i.e. the frequency range of the input signal in to be amplified.

The Doherty amplifier 100 further comprises a plurality of secondary amplification paths, presently two secondary amplification paths 120a, 120b. The secondary amplification paths 120a, 120b are basically identical regarding their structure as compared to the primary amplification path 110. Thus, the secondary amplification path 120a comprises an amplifier 122a as well as an input matching network 124a and an output matching network 126a. Likewise, the secondary amplification path 120b comprises an amplifier 122b and associated input and output matching networks 124b, 126b.

In contrast to the main wideband amplifier 112 of the primary amplification path 110, the amplifiers 122a, 122b of the secondary amplification paths 120a, 120b are each optimized for amplifying signals within a frequency sub-range of the common input signal in supplied to the Doherty amplifier 100. I.e., according to a preferred embodiment, the amplifiers 122a, 122b are no wideband amplifiers in the sense of the main amplifier 112, but they are rather optimized for a smaller frequency range, i.e. a sub-range, which may e.g. be centered around important center frequencies the input signal in to be amplified by the Doherty amplifier 100 may comprise.

Thus, depending on the spectral properties of the input signal in, either one of the secondary amplification paths 120a, 120b may be operated together with the main, i.e. primary, amplification path 110 for optimized signal amplification based on the Doherty amplifier principle. However, according to a further embodiment, it is also possible to operate both secondary amplification paths 120a, 120b (or in case of more than two secondary amplification paths, all) simultaneously together with the primary amplification path 110, whereby a plurality of different frequency sub-ranges can be supported in an optimized way by the secondary amplification paths 120a, 120b.

As can be seen from figure 1, the output signals of the different amplification path 110, 120a, 120b are forwarded to an output signal combining network 140, which is configured to combine the output signals according to a predetermined scheme. For instance, the combining network 140 may be configured to combine the different output signals according to different weighting factors associated with the respective output signals or amplification paths 110, 120a, 120b, respectively. At an output of the combining network 140, a corresponding aggregated output signal RF_out is obtained, which represents the amplified version of the common input signal in. According to the present invention, the Doherty amplifier 100 also comprises processing means 130, which are preferably arranged at an input section, and which comprise at least two preprocessing branches 132, 134, 136. A first preprocessing branch 132 is configured to supply the primary amplification path 110 with the primary input signal in1 derived from said common input signal in. I.e., the primary input signal in1 is a signal that has been derived from the common input signal in individually for the primary amplification path 110. Thus, advantageously, the primary input signal in1 may be optimized for the further processing steps within the primary amplification path 110 without affecting the operation of the further amplification paths 120a, 120b.

At least one further preprocessing branch 134 is configured to supply at least one of said secondary amplification paths 120a with the secondary input signal in2. Likewise, the third preprocessing branch 136 of the processing means 130 are configured to provide the third amplification path 120b with a further secondary input signal in3, which is also derived from the input signal in to the Doherty amplifier 100.

The various preprocessing branches 132, 134, 136 advantageously allow for a signal processing of the common input signal in on a per-amplification path basis. In other words, by providing the various preprocessing branches 132, 134, 136, the processing means 130 advantageously enable to individually (pre-)process the common input signal in for optimization regarding a subsequent processing by the different amplification paths 110, 120a, 120b.

Thus, for instance, the secondary input signal in1 may be optimized within the first preprocessing branch 132 for the subsequent processing by means of the primary amplification path 110. Likewise, within the second preprocessing branch 134, an optimized secondary input signal in2 may be derived from the input signal in with regard to the further processing within the secondary amplification path 120a. For example, specific signal processing algorithms may be applied within preprocessing branch 134 which account for a further amplification of the input signal in2 by the amplifier 122a, which, according to a preferred embodiment, is not a wideband amplifier-as compared to the main amplifier 112. Likewise, the third preprocessing branch 136 may provide individual signal processing/preprocessing to obtain an optimized secondary input signal in3 for the second secondary amplification path 120b.

According to a particularly preferred embodiment, the operation of the preprocessing branches 132, 134, 136 is controlled by the control unit 130a, which may also be implemented within the signal processing means 130. Generally, the functionality of the signal processing means 130 and its preprocessing branches 132, 134, 136 may e.g. at least partly be implemented in the form of a digital signal processor. Additionally or alternatively, analog signal processing circuitry may also be employed to implement the processing means 130.

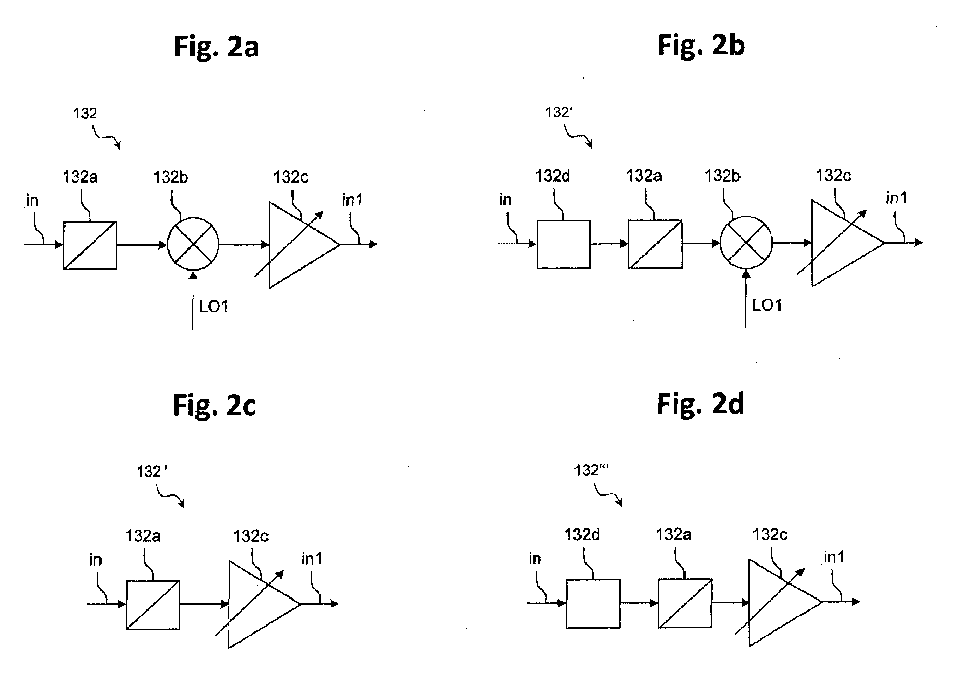

Figure 2a depicts a simplified block diagram of a preprocessing branch 132 according to a first embodiment. The preprocessing branch 132 comprises an analog to digital converter 132a which is configured to convert the input signal in, which may be a digital baseband signal, to the analog domain. The corresponding analog output signal of the digital to analog converter 132a is forwarded to a mixer 132b which is configured to perform an upconversion of the analog output signal depending on a local oscillator signal LO1. Thus, at an output of the mixer 132b, an upconverted analog signal is obtained which comprises frequency components within the desired target frequency range as defined by the local oscillator signal L01. After upconversion, the upconverted signal is processed by the controllable amplifier 132c which is configured to apply a controllable gain and/or attenuation to the upconverted signal, whereby a secondary input signal in1 is obtained at an output of the amplifier 132c. The secondary input signal in1 may e.g. be provided as an input signal to the primary amplification path 110 (figure 1) of the Doherty amplifier 100. The controllable amplifier 132c may e.g. be controlled by the control unit 130a (figure 1). According to a further embodiment, however, the amplifier 132c may also provide for a fixed gain or attenuation.

Figure 2b depicts a simplified block diagram of a preprocessing branch 132' according to a further embodiment. In contrast to the preprocessing branch 132 depicted by figure 2a, the preprocessing branch 132' of figure 2b additionally comprises local digital signal processing means 132d which advantageously enable to locally perform digital signal processing steps or algorithms, respectively, that may be employed to further condition the input signal in1 that is to be forwarded to one of the amplification paths 110, 120a, 120b of the Doherty amplifier 100 (figure 1).

Figure 2c depicts a further embodiment of a preprocessing branch 132", which, in contrast to the preceding embodiments explained with reference to figure 2a, 2b, does not comprise a mixer. The configuration according to figure 2c may e.g. be employed if the input signal in already is in a desired frequency range such us an intermediate frequency range or a radio frequency range so that no further upconversion is to be effected within the preprocessing branch 132". However, a controllable amplifier 132c may be provided within the preprocessing branch 132" to effect a controllable gain/amplification as already explained above.

Figure 2d depicts a further preprocessing branch architecture 132 "', which differs from the preceding embodiment according to figure 2c by comprising local digital signal processing means 132d which again advantageously enable a local digital signal processing within the preprocessing branch 132"' . Such digital processing may e.g. comprise applying a controllable gain in the digital domain, applying a predetermined delay to account for delay non-uniformities between the different amplification paths 110, 120a, 120b of the Doherty amplifier 100 (figure 1), and the like.

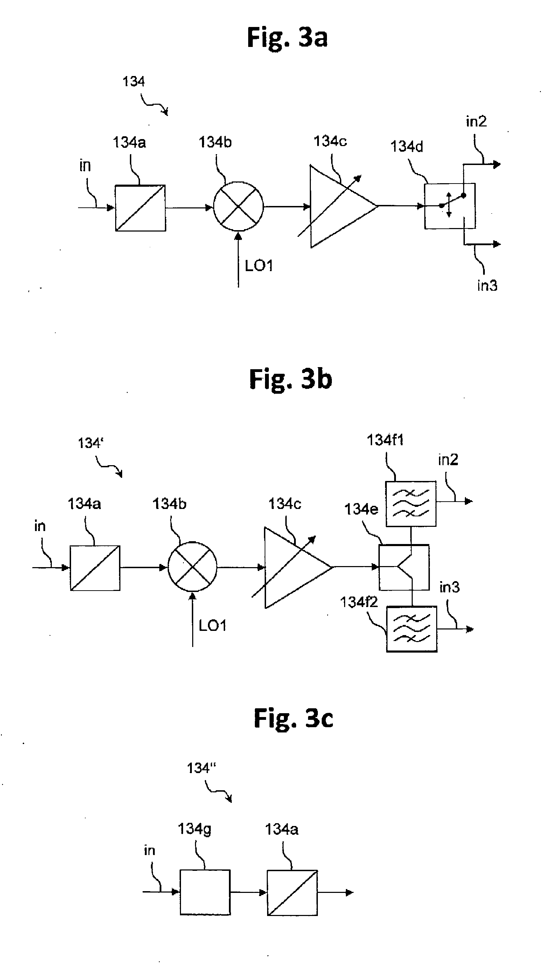

Figure 3a depicts a simplified block diagram of an exemplary architecture of the further preprocessing branch 134 according to an embodiment. The components 134a (D/A converter), 134b (mixer), 134c (controllable amplifier) are comparable in function to the elements 132a, 132b, 132c of the embodiment according to figure 2a. However, at an output of the controllable amplifier 134c, switching means 134d are provided which are controllable as indicated by the double arrow so as to selectively connect an output of the amplifier 134c to a first output terminal of the switching means 134d or a second output terminal of the switching means 134d. Thus, when providing the preprocessing branch 134 for supplying both secondary amplification paths 120a, 120b (figure 1) with respective input signals in2, in3, the secondary amplification path 120a may e.g. be connected to the first output terminal of the switching means 134d, whereas the further secondary amplification path 120b (figure 1) of the Doherty amplifier 100 may be connected to the second output port of the switching means 134d thus enabling to selectively provide the respective amplification path 120a, 120b with the output signals in2, in3 as processed within the preprocessing branch 134.

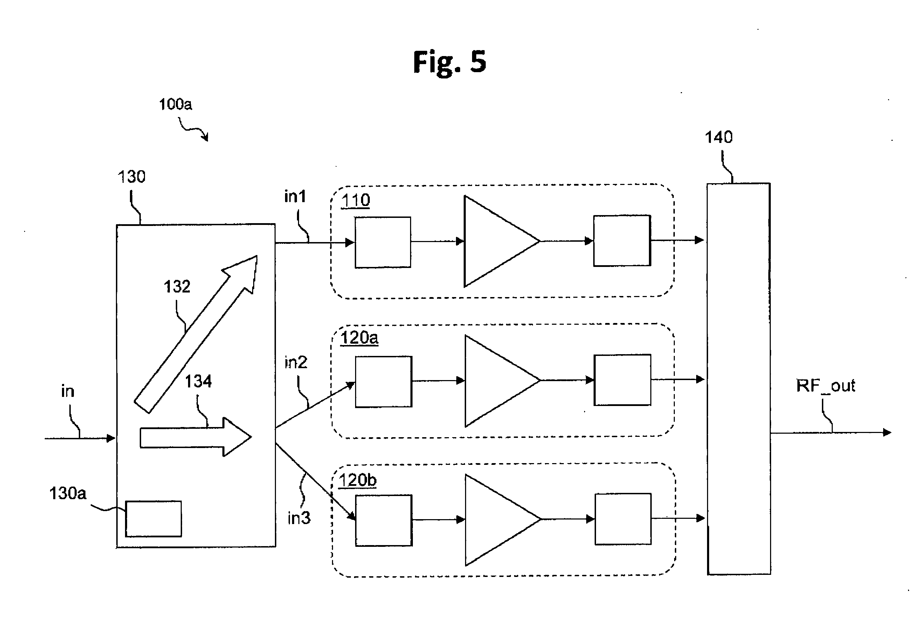

For instance, the preprocessing branch architecture 134 according to figure 3a may be employed to implement the further embodiment 100a of the Doherty amplifier as depicted by figure 5. In contrast to the embodiment according to figure 1, the embodiment according to figure 5 comprises only two preprocessing branches 132, 134, wherein the second preprocessing branch 134 is e.g. configured in accordance with figure 3a. Thus, the second preprocessing branch 134 can selectively provide the first or second secondary amplification path 120a, 120b with the respective input signal in2, in3.

The further components of the embodiment 100a of figure 5 have already been explained in combination with the embodiment according to figure 1.

Figure 3b depicts a further embodiment 134' of a preprocessing branch. The preprocessing branch 134' also comprises a basic configuration comprising a digital to analog converter 134a, a mixer 134b and a controllable amplifier 134c. However, at an output of the controllable amplifier 134c, power splitter means 134e are provided which enable to divide the output signal of the amplifier 134c into two signal branches, each of which is fed to respective filter means 134f1, 124f2, preferably bandpass filter means, which perform a filtering process of the output signal of the amplifier 134c. Thus, different input signals in2, in3 for further amplification by means of the secondary amplification paths 120a, 120b (figure 1) of the Doherty amplifier 100 can be obtained. The embodiment according to figure 3b is particularly advantageous in such cases, where a single preprocessing branch 134' is to provide input signals in2, in3 having different center frequencies to the subsequent amplification paths 120a, 120b. As such, the filtering means 134f1, 134f2 may e.g. be optimized regarding their passband range so as to accommodate the corresponding center frequencies of the common input signal in.

Figure 3c depicts a further embodiment of a preprocessing branch 134", which comprises local digital signal processing means 134g and a digital to analog converter 134a. As such, the configuration 134" according to figure 3c is capable of performing local digital signal processing and converting a so obtained digital signal to the analog domain, which can also be fed to one or more amplification paths 110, 120a, 120b of the Doherty amplifier 100.

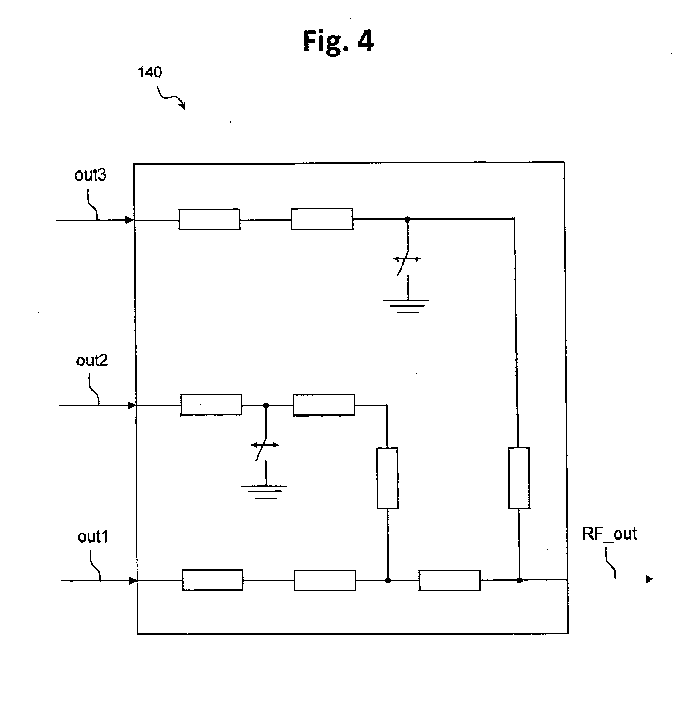

Figure 4 depicts an output signal combining network 140 according to an embodiment. The output signal combining network 140 receives at its inputs respective output signals out1, out2, out3 of the various amplification paths 110, 120a, 120b (figure 1). The combining network 140 may e.g. comprise a plurality of transmission line structures and radio frequency switches, which are not explained in detail for the sake of clarity. The combining network 140 is configured to add the various output signals out1, out2, out3 to obtain the aggregated output signal RF_out.

For instance, by controlling the switches depicted in figure 4, the processing means 130 (figure 1) or the control unit 130a, respectively, may activate or deactivate a respective signal path receiving one of the output signals out2, out3 from the respective amplification paths 120a, 120b.

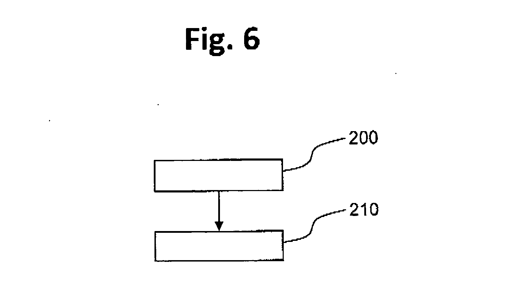

Figure 6 depicts a simplified flowchart of a method according to the embodiments.

In a first step 200, a first preprocessing branch 132 (figure 1) supplies the primary amplification path 110 of the Doherty amplifier 100 with a primary input signal in1 derived from said common input signal in. In the same step 200, at least one further preprocessing branch 134 supplies at least one of said secondary amplification paths 120a, 120b with a secondary input signal in2, in3 also derived from said common input signal in.

After that, in step 210, the respective input signals in1, in2, in3 are amplified by means of the various amplification paths 110, 120a, 120b of the Doherty amplifier 100.

The provisioning of the individual input signals in1, in2, in3 for the respective amplification paths 110, 120a, 120b of the Doherty amplifier 100, which is enabled by the processing means 130 or its preprocessing branches 132, 134, 136, respectively, advantageously enables an increased operational flexibility of the Doherty amplifier operation and thus an increased linearity and power efficiency. For instance, the various preprocessing branches 132, 134, 136 advantageously enable to provide individual delays and/or gains / attenuations to the common input signal in thus forming specific secondary input signals in1, in2, in3 which can be optimized for their respective amplification path 110, 120a, 120b. Different bandpass or other filtering operations as well as general digital signal processing algorithms (cf. the local digital signal processing means 132d, 134g) may also be applied on a per preprocessing branch basis.

The embodiments thus advantageously combine a multi-band Doherty amplifier architecture with a digital control implemented by means of the digital signal processing means 130 and its respective preprocessing branches 132, 134, 136, whereby a highly efficient digitally controllable multiband capable Doherty configuration is provided.

Generally, if the amplifiers 122a, 122b of the secondary amplification paths 120a, 120b are configured as peak amplifiers in the sense of the Doherty amplifier principle, a currently not required amplifier (and/or its active components such as e.g. power transistors) may be switched off thus contributing to increased energy efficiency.

## Claims

1. Doherty amplifier (100) comprising a primary amplification path (110) for amplifying an input signal (in), a plurality of secondary amplification paths (120a, 120b) for amplifying specific frequency sub-ranges of said input signal (in), and signal processing means (130) which comprise at least two preprocessing branches (132, 134, 136), wherein a first preprocessing branch (132) is configured to supply said primary amplification path (110) with a primary input signal (in1) derived from said input signal (in), and wherein at least one further preprocessing branch (134, 136) is configured to supply at least one of said secondary amplification paths (120a, 120b) with a secondary input signal (in2, in3) derived from said input signal (in).

2. Amplifier (100) according to claim 1, wherein at least one preprocessing branch (132) comprises a mixer (132b) for upconverting a signal processed within said preprocessing branch (132).

3. Amplifier (100) according to one of the preceding claims, wherein at least one preprocessing branch, (132) comprises amplifying means (132c) for applying a, preferably controllable, gain and/or attenuation to a signal processed within said preprocessing branch (132).

4. Amplifier (100) according to one of the preceding claims, wherein at least one preprocessing branch (132) comprises digital to analog, D/A, converter means (132a).

5. Amplifier (100) according to one of the preceding claims, wherein at least one preprocessing branch (132) comprises digital signal processing means (132d) for applying digital signal processing algorithms to a signal processed within said preprocessing branch (132).

6. Amplifier (100) according to one of the preceding claims, wherein said at least one further preprocessing branch (134, 136) comprises switching means (134d) for selectively supplying at least one of said secondary amplification paths (120a, 120b) with said secondary input signal (in2, in3).

7. Amplifier (100) according to one of the preceding claims, wherein said at least one further preprocessing branch (134, 136) comprises splitter means (134e) for supplying a plurality of said secondary amplification paths (120a, 120b) with said secondary input signal (in2, in3).

8. Amplifier (100) according to one of the preceding claims, wherein said at least one further preprocessing branch (134, 136) comprises filter means (134fl, 134f2) for filtering a signal processed within said preprocessing branch (134, 136).

9. Amplifier (100) according to one of the preceding claims, wherein an output signal combining network (140) is provided which is configured to receive output signals (out1, out2, out3) of a plurality of amplification paths (110, 120a, 120b) and to add said output signals (out1, out2, out3) to obtain an aggregated output signal (RF_out).

10. Amplifier (100) according to one of the preceding claims, wherein said signal processing means (130) are configured to apply at least one of the following processing steps to said input signal (in):
linearization, clipping, digital path control for distributing specific portions of said input signal (in) to different preprocessing branches (132, 134, 136).

11. Amplifier (100) according to one of the preceding claims, wherein a control unit (130a) is provided which is configured to control an operation of said amplifier (100), particularly configured to:
- control a gain and/or attenuation applied to a signal processed within a preprocessing branch (132, 134, 136),
- control switching means (134d) of said preprocessing branch (134, 136),
- control a supply voltage for an amplifier comprised within said primary amplification path (110) and/or said secondary amplification path (120a, 120b),
- control an operation of said output signal combining network (140).

12. Method of operating a Doherty amplifier (100) comprising a primary amplification path (110) for amplifying an input signal (in), a plurality of secondary amplification paths (120a, 120b) for amplifying specific frequency sub-ranges of said input signal (in), and signal processing means (130) which comprise at least two preprocessing branches (132, 134, 136), wherein a first preprocessing branch (132) supplies said primary amplification path (110) with a primary input signal (in1) derived from said input signal (in), and wherein at least one further preprocessing branch (134, 136) supplies at least one of said secondary amplification paths (120a, 120b) with a secondary input signal (in2, in3) derived from said input signal (in).

13. Method according to claim 12, wherein a single one of said secondary amplification paths (120a, 120b) is activated at a time by a control unit (130a).

14. Method according to one of the claims 12 to 13,
wherein a plurality of preprocessing branches (132, 134, 136) use the same local oscillator signal (L01) for upconverting a signal processed within said preprocessing branches (132, 134, 136).

15. Method according to one of the claims 12 to 14,
wherein the primary and secondary input signals (in1, in2, in3) are processed individually for at least two, preferably all, amplification paths (110, 120a, 120b), within the preprocessing branches (132, 134, 136).
